(19) Europäisches Patentamt
European Patent Office
Office européen des brevets

(11) Numéro de publication: **0 246 169**
**A1**

(12) # DEMANDE DE BREVET EUROPEEN

(21) Numéro de dépôt: **87420085.0**

(22) Date de dépôt: **30.03.87**

(51) Int. Cl.[4]: **C 08 L 83/07**
// G03F7/10, (C08L83/07, 83:05)

(30) Priorité: **14.04.86 FR 8605483**

(43) Date de publication de la demande:
**19.11.87 Bulletin 87/47**

(84) Etats contractants désignés:
**AT BE CH DE ES FR GB IT LI LU NL SE**

(71) Demandeur: **RHONE-POULENC MULTI-TECHNIQUES**
**25 Quai Paul Doumer**
**F-92408 Courbevoie Cedex (FR)**

(72) Inventeur: **Cavezzan, Jacques**
**Résidence du Parc Tête d'Or 4, Allée Marcel Achard**
**F-69100 Villeurbanne (FR)**

**Dumas, Sylviane**
**721, Av du Pré aux Clercs Le Molière E2**
**F-34100 Montpellier (FR)**

**Giral, Louis**
**Les Deux Ruisseaux No. 2 1526, Av du Père Souias**
**F-34100 Montpellier (FR)**

**Prud'Homme, Christian**
**19, rue du Cnt Faurax**
**F-69006 Lyon (FR)**

**Schue, François**
**33, rue des Mimosas**
**F-67000 Strasbourg Robertsau (FR)**

(74) Mandataire: **Varnière-Grange, Monique et al**
**RHONE-POULENC INTERSERVICES Service Brevets**
**Chimie Centre de Recherches de Saint-Fons B.P. 62**
**F-69192 Saint-Fons Cédex (FR)**

(54) **Utilisation d'une composition organo-polysiloxane, potentiellement réticulable comme résist négatif, notamment en microlithographie, et son procédé d'application.**

(57) La présente invention concerne l'utilisation comme photorésist négatif d'une composition organopolysiloxane filmogène et réticulable par réaction d'hydrosilylation en présence d'un catalyseur issu d'un métal du groupe du platine, l'activité du catalyseur étant bloquée de manière réversible par un inhibiteur, le déblocage de l'activité catalytique étant pour l'essentiel réalisable par insolation à la lumière ultra-violette comprenant essentiellement : 1) au moins un organopolysiloxane contenant par molécule au moins x groupes hydrocarbonés à insaturation alcényle liés à un atome de silicium, avec x supérieur ou égal à 2,

2) au moins un organohydrogénopolysiloxane contenant par molécule au moins y atomes d'hydrogène liés à un atome de silicium avec y supérieur ou égal à 2,
(x + y) étant supérieur ou égal à 5, les groupements SiH et Si-alcényle pouvant être portés par la même molécule,

3) une quantité catalytiquement efficace d'un composé d'un métal du groupe du platine,

4) une quantité d'au moins un azodicarboxylate efficace pour inhiber la formation d'un gel à température ambiante mais en quantité insuffisante pour empêcher la réticulation lors de l'insolation au rayons ultra-vilolets, et

5) le cas échéant, un solvant organique.

L'invention concerne également un substrat revêtu d'un film formé à partir d'une telle composition et un procédé d'imageage d'un tel substrat.

EP 0 246 169 A1

## Description

### UTILISATION D'UNE COMPOSITION ORGANOPOLYSILOXANE, POTENTIELLEMENT RETICULABLE COMME RESIST NEGATIF, NOTAMMENT EN MICROLITHOGRAPHIE, ET SON PROCEDE D'APPLICATION

La présente invention concerne l'utilisation d'une composition organopolysiloxane, potentiellement réticulable comme résist négatif notamment en micro-lithographie, et son procédé d'application.

Des avancées significatives ont été accomplies ces dernières années, tant sur le plan de la réduction des dimensions que sur celui de la diminution des coûts des composants électroniques, grâce aux progrès réalisés dans la technologie de fabrication de circuits de microélectronique, par exemple, dans le domaine de la microlithographie. Le processus de la microlithographie comprend généralement :

a) l'application d'un film d'un matériau polymérique sensible aux radiations "un résist" sur l'une des surfaces du substrat,

b) l'insolation de certaines parties du film par la lumière ultra-violette, un faisceau d'électrons, des rayons X, etc... par exemple et,

c) le développement du film à l'aide d'un solvant pour en élimer les parties solubles.

S'agissant des matériaux polymériques, des "résists", l'usage les classe en deux catégories selon leur comportement sous irradiation.

Certaines résines se caractérisent par une solubilité accrue après irradiation et conduisent à une image en creux ; ces résines sont dites positives. Les autres deviennent insolubles dans un solvant de révélation après irradiation et elles conduisent à une image en relief ; ces résines sont dites négatives.

Dans tous les cas, la partie "de résist" qui reste sur le substrat est utilisée comme protection pour faciliter la gravure sélective ou tout autre traitement des parties non revêtues du substrat.

La gravure du substrat peut être réalisée par une attaque chimique conventionelle ou par un plasma. La gravure par un plasma permet généralement d'atteindre une résolution plus fine que celle obtenue par attaque chimique et elle permet en outre de supprimer la pollution et les problèmes de manipulation inhérents aux agents chimiques. Cependant de nombreuses résines ne résistent pas à la décharge du plasma et sont, elles aussi, érodées avec le substrat, ce qui conduit irrémédiablement à une perte en résolution de l'image.

Parallèlement à ces démarches, il y a lieu de noter que la complexité et la miniaturisation croissantes des circuits intégrés mettent en évidence les limites des technologies ne recourant qu'à un niveau ou qu'à une couche "de résist". C'est ainsi que divers travaux antérieurs, recensés, par exemple, dans "Solid State Technology/août 1985, pages 130-135", ont proposé de résoudre, au moins partiellement, les problèmes posés par la topographie et la réflexion d'un substrat, telle une tranche de silicium, en utilisant plusieurs niveaux ou couches de "résists".

Ainsi il a été proposé de déposer une première couche relativement épaisse d'un matériau polymérique, dite couche de planéification et de revêtir cette première épaisseur d'une fine couche sensible aux radiations, résistante au plasma et formée à partir d'un polymère contenant du silicium.

Il y a donc une recherche continue de matériaux polymériques ayant une sensibilité accrue aux radiations pour réaliser des motifs de plus grande résolution en réponse à la demande en faveur d'une circuiterie de plus en plus fine.

Bien entendu, cette recherche est conduite en parallèle avec le developpement de nouvelles technologies.

La présente invention a plus particulièrement trait au domaine des "résists" négatifs, c'est à dire à des compositions ou matériaux polymériques qui deviennent insolubles dans un solvant de révélation après insolation, notamment au rayonnement ultra-violet (U.V.).

On connait dejà des systèmes dans lesquels un initiateur de réactions chimiques, réactions qui impliquent soit la chaîne principale soit les groupements latéraux d'un polymère et qui entraînent une modification profonde de la solubilité et/ou de la résistance à la gravure au plasma de ce polymère, est activée sous l'action d'un rayonnement U.V..

Ainsi dans le brevet des Etats Unis d'Amérique nº 3.984.253 est mise en évidence la sensibisation d'un polyaldéhyde phtalique aux radiations U.V., à un faisceau d'électrons ou aux rayons X par introduction de composés générateurs d'acide tels des sels de diazonium pour former une image positive.

On connaît aussi (cf. brevet américain nº 4.491.628) un système dans lequel on génère un acide par irradiation, l'acide ainsi généré est utilisé pour cliver des groupes acides labiles pendant sur des chaînes latérales d'un polymère. Les parties irradiées diffèrent des parties non exposées par leur polarité et leur solubilité ; elles peuvent être alors éliminées sélectivement par des traitements de développements alcalins ou des solvants polaires. Les parties non exposées peuvent être éliminées sélectivement au moyen d'un solvant non polaire. Toutefois la plupart des compositions utilisables à cette fin forment après développement des couches solides ne résistant pas au plasma. Par ailleurs, le choix des solvants utilisés lors du développement est très critique.

On sait aussi que les polysiloxanes figurent parmi les tous premiers polymères inorganiques envisagés pour la préparation "de résists" à deux couches. Toutefois ces copolymères de diméthylsiloxane, de méthylphénylsiloxane et/ou méthylvinylsiloxane ne sont sensibles au rayonnement U.V. proche que dans la mesure où l'on a pris le soin d'introduire des groupes sensibles dans leur structure, par exemple des groupements acrylique ou méthacrylique, introduction par ailleurs délicate à conduire.

Il a également été proposé (cf. JA 60/057833) d'utiliser comme "résist" capable de résister au plasma à

oxygène des polysiloxanes à structure dite "en échelle" de formule : dans laquelle :

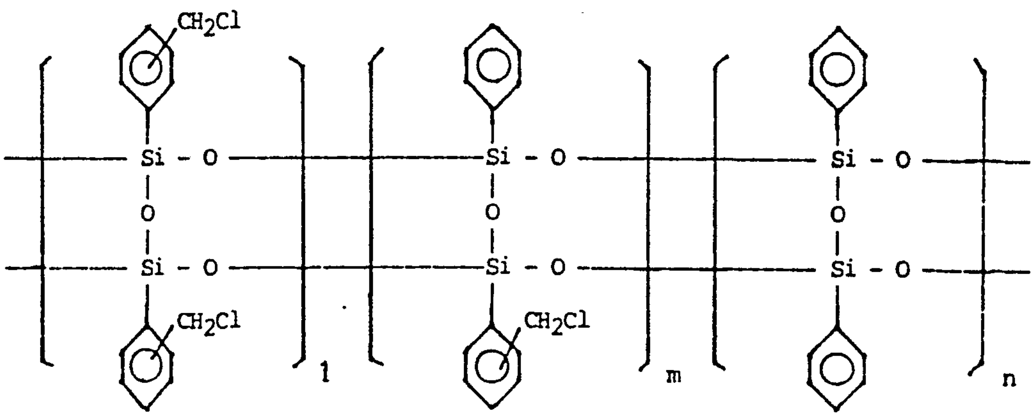

1, m et n sont des entiers positifs pouvant être nuls, sous réserve toutefois que 1 et m ne soient pas simultanément nuls

Nonobstant le fait que ces produits sont relativement difficiles à synthétiser, ils entrent, eux aussi, dans un système dans lequel se déroule une photosensibilisation directe agissant par photochimie sensiblement pure, c'est à dire que chaque photon active un groupement chimique pendant sur la chaîne principale du polymère, ce qui implique que l'importance de la réticulation ou de la scission observée, selon le cas considéré est directement proportionnelle à la quantité d'énergie lumineuse appliquée.

Au contraire dans le système selon la présente invention, la photosensibilisation intervient de manière "indirecte" c'est à dire, qu'un photon débloque l'activité catalytique. La réticulation est alors susceptible de se dérouler pour des quantités d'énergie appliquée plus faible. Du fait de l'amplification chimique, les compositions selon l'invention présentent une haute sensibilité aux U.V. et autorisent une augmentation des cadences de production. En outre, la présence de composés organosiliciques apporte une résistance à la gravure au plasma.

Par ailleurs le système selon la présente invention repose sur une réaction bien connue en elle-même, à savoir la réaction d'hydrosilylation de matières polymériques ou non, comportant des groupements Si-alcényle, réaction sélective, rapide et à haut rendement qui n'a jamais été utilisée à cette fin, à la connaissance de la demanderesse. L'hydrosilylation met en cause la réaction d'un composé organique du silicium ayant au moins un atome de silicium relié à un atome d'hydrogène avec un composé comportant au moins un atome de silicium relié à un atome de carbone d'un groupement à insaturation alcényle sans former de co-produit.

La présente invention a donc pour objet l'utilisation comme résist négatif d'un composition organopolysiloxane filmogène et réticulable par réaction d'hydrosilylation en présence d'un catalyseur issu d'un métal du groupe du platine, l'activité du catalyseur étant bloquée de manière réversible par un inhibiteur, le déblocage de l'activité catalytique étant pour l'essentiel réalisable par insolation à la lumière ultra-violette, comprenant essentiellement :

1) au moins un organopolysiloxane contenant par molécule au moins x groupes hydrocarbonés à insaturation alcényle liés à un atome de silicium, avec x supérieur ou égal à deux,

2) au moins un organohydrogénopolysiloxane contenant par molécule au moins y atomes d'hydrogène liés à un atome de silicium avec y supérieur ou égal à deux,

$(x+y)$ étant supérieur ou égal à cinq,

les groupements Si-H et Si-alcényle pouvant être portés par la même molécule,

3) une quantité catalytiquement efficace d'un composé d'un métal du groupe du platine,

4) une quantité d'au moins un azodicarboxylate efficace pour inhiber la formation d'un gel à température ambiante mais en quantité insuffisante pour empêcher la réticulation lors de l'insolation aux rayons ultra-violets, et

5) le cas échéant, un solvant organique.

La présente invention a également pour objet un substrat comportant au moins une surface revêtue d'un film adhérent uniforme, d'une épaisseur comprise entre 0,1 et 3 micromètres environ, formé à partir de la composition, et un procédé d'application de la composition pour former une image sur un substrat.

Le premier composant entrant dans la composition en cause est un organopolysiloxane contenant par molécule au moins x groupes hydrocarbonés à insaturation alcényle liés à un atome de silicium, avec x supérieur ou égal à deux. Ce composant peut être "sensiblement linéaire" c'est à dire être un polymère ou un copolymère à chaîne droite ou en partie ramifiée. Les groupes à insaturation alcényle, de préférence vinyle, peuvent être situés à l'extrémité de la chaîne du polymère et/ou dans la chaîne. Ce premier composant peut

présenter une viscosité comprise entre environ 50 et 100 000 m Pa.s à 25°C.Ce peut être un diorganopolysiloxane renfermant de 1,9 à 2,1 radicaux organiques par atome de silicium. Les radicaux organiques (autres que les radicaux à insaturation alcényle) peuvent être de n'importe quel type dans la mesure où ces radicaux sont exempts d'insaturation aliphatique et où ils n'exercent pas d'influence défavorable sur l'activité catalytique du constituant (3) de la composition. A titre d'exemples de tels radicaux on peut citer les radicaux méthyle, éthyle, phényle et trifluoro-3,3,3 propyle. Ces composés sont bien connus et sont décrits notamment dans les brevets américains no3.220.972, 3.344.111 et 3.434.366.

Jusqu'à 80 % en poids de ce polymère peut être remplacé par un produit résineux qui est un copolymère organopolysiloxane choisi parmi ceux constitués sensiblement de motifs triméthylsiloxane, méthylvinylsiloxane et $SiO_2$ dans lequel de 2,5 à 10 % molaire des atomes de silicium comportent un groupe vinyle et dans lequel le rapport molaire des groupes triméthylsiloxane aux groupes $SiO_2$ est compris entre 0,5 et 1. De tels copolymères résineux utilisables dans le cadre de la présente invention sont décrits dans les brevets américains no 3.284.406 et 3.436.366 cités comme références.

La composition peut également contenir un composé cycloorganosiloxane présentant des groupements vinyle et méthyle sous forme d'un tétramère tel le tétraméthyl-1,3,5,7 tétravinyl-1,3,5,7 cyclotétrasiloxane.

Le composant (2) est un organohydrogénopolysiloxane contenant par molécule au moins y atomes d'hydrogène liés à un atome de silicium, y étant supérieur ou égal à deux. Ce composant qui peut être linéaire ou cyclique a avantageusement une viscosité située entre 10 et 100 000 m Pa.s à 25°C.

La teneur en poids des atomes d'hydrogène liés au silicium ne dépasse pas 1,67 et est de préférence comprise entre 0,1 et 1,6 % pour les polymères ne comportant que les groupements SiH et $Si\text{-}CH_3$.

Les valences du silicium qui ne sont pas saturées par des atomes d'hydrogène et des atomes oxygène sont saturées, de préférence par des groupes méthyle, éthyle et/ou phényle.

Les groupements SiH peuvent se situer à l'intérieur ou aux extrémités ou à l'intérieur et aux extrémités de l'organohydrogénopolysiloxane.

On peut par exemple citer le polyméthylhydrogénosiloxane à extrêmité triméthylsiloxy, le copolymère polydiméthylpolyméthylhydrogénosiloxane à extrêmité triméthylsiloxy, le copolymère polydiméthylpolyméthylhydrigénosiloxane à extrêmité hydrogénodiméthylsiloxy.

Les composés (2) sont bien connus et sont par exemple décrits dans les brevets US 3.220.972, 3.341.111 et 3.436.366 et 3.697.473.

Jusqu'à 80 % en poids ce polymère peut être remplacé par un produit résineux qui est un organopolysiloxane portant des motifs siloxanes mono-, di- ou trifonctionnels dont certains portent des groupes SiH ; des exemples de tels motifs répondent aux formules suivantes :

R H SiO , H si $O_{1,5}$ , H Si $_{0,5}$ ,

dans lesquelles R représente un radical méthyle, éthyle, n-propyle, phényle, ou trifluoro-3,3,3 propyle.

Des résines hydrogénées telles que celles décrites notamment dans les brevets américains no 3.284.406 et 3.486.366 cités comme référence peuvent être utilisées à cette fin.

La composition peut également contenir un composé cycloorganosiloxane portant des groupements méthyle et des atomes d'hydrogène sur des atomes de silicium sous forme d'un tétramère tel le tétraméthyl-1,3,5,7 tétrahydrogéno-1 cyclotétrasiloxane.

En général la quantité totale de résine pourra représenter 80% en poids de la matière sèche de la composition sous réserve toutefois qu'elle reste soluble dans les solvants organiques.

Comme indiqué précédemment des groupements SiH et si-vinyle peuvent être portés par un copolymère formant un seul polysiloxane.

La somme du nombre de groupes à insaturation (alcényle, de préférence vinyle) par molécule de composé (1) et du nombre de groupement SiH par molécule de composé (2) doit être égale ou supérieure à 5 de façon à obtenir un réticulat lors de la réticulation de la composition organopolysiloxane.

Le rapport du nombre des groupements SiH aux groupements vinyle est supérieur généralement à 0,4 et généralement inférieur à 2 et est compris de préférence entre 0,7 et 1,4.

On peut utiliser comme catalyseur (3) des complexes d'un métal du groupe du platine, notamment les complexes de platine-oléfine comme décrits dans les brevets US 3.159.601 et 3.159.662, les produits de réaction des dérivés du platine avec des alcools, des aldéhydes et des éthers décrits dans le brevet US 3.220.972, les catalyseurs platine-vinylsiloxane décrits dans les brevets français 1.313.846 et son addition 88 676 et le brevet français 1.480.409 ainsi que les complexes décrits dans les brevets US 3.715.334, 3.775.452 et 3.814.730, un catalyseur au rhodium tel que décrit dans les brevet US 3.296.291 et 3.928.629.

Les métaux préférés du groupe du platine sont le platine et le rhodium ; le ruthénium bien que moins actif mais moins cher, est également utilisable.

Des résultats particulièrement intéressants sont observés avec des complexes platine-vinylsiloxane, en particulier le complexe de divinyl-1,3 tétraméthyl-1,1,3,3 disiloxane et des complexes platine-méthylvinylcyclotétrasiloxane, en particulier le complexe platine tétraméthyl-1,3,5,7, tétravinyl-1,3,5,7 cyclotétrasiloxane.

Les azodicarboxylates utilisés dans le cas présent comme inhibiteurs (4) dans la composition sont caractérisés par le fait qu'ils comprennent le groupe :

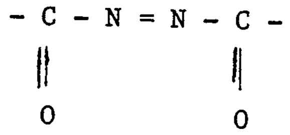

chaque groupe carboxylique étant relié à un radical organique sans influence défavorable sur l'activité catalytique du composé (4), et en ce qu'ils se présentent à l'état liquide à 25°c ou, s'ils sont solides à cette température en ce qu'ils sont solubles dans un solvant organique compatible avec les compositions organopolysiloxanes.

Ils peuvent être plus précisément représentés par l'une ou l'autre des formules (I) et (III) ci-après ;

$R_1$ O O C - N = N - C O O $R_2$ (1)

dans laquelle $R_1$ et $R_2$ identiques ou différents représentent un radical alkyle linéaire ou ramifié ayant de 1 à 12 atomes de carbones, de préférence de 1 à 4 atomes de carbone.

Les produits répondant à la formule (1) sont la plupart des produits connus dont le procédé de préparation est notamment décrit par Ingold et Weaver J Chem. Soc. vol. 127, p. 378-387, cité comme référence où l'on décrit plus spécialement la synthèse de l'azodicarboxylate d'éthyle.

$R'_1$ O O C - N = N - R - O O C - N = N - C O O $R'_2$ (II)

dans laquelle $R'_1$ et $R'_2$ ont la même signification que ci-dessus et -R- est une chaîne alkylène de formule $-(CH_2)-$ avec n étant un nombre entier compris entre 1 et 12, ou une chaîne :

$-CH_2-CH_2-O-CH_2-CH_2-$

La synthèse de ces produits est décrite par Norman Rabjohn, Journal of the American Chemical Society, mars 1948, vol. 70, p.1181-1183 cité comme référence.

L'azodicarboxylate d'éthyle et l'azodicarboxylate de méthyle conviennent plus particulièrement.

La quantité de complexe de catalyseur (3) et d'inhibiteur (4) à ajouter est fonction notamment des compositions et du type de catalyseur. De façon générale, la teneur en catalyseur est comprise entre environ 5 et 1 000 ppm, de préférence entre 10 et 100 ppm (calculés en poids de métal précieux et rapportés aux polysiloxanes).

On a découvert que de très petites quantités d'inhibiteurs selon l'invention, permettent d'augmenter la stabilité des compositions et d'un film formé à partir de ces compositions conservé(es) à température ambiante ordinaire c'est à dire inférieure à 45 °C environ sans pour cela affecter le temps de durcissement d'un film formé à partir d'une telle composition exposé au rayonnement ultra-violet. Par ailleurs , il est important de noter qu'un film formé à partir d'une telle composition peut être séché à une température pouvant atteindre 50°C pendant 1 heure sans que sa solubilité soit modifiée. La composition selon l'invention peut comprendre également une quantité plus ou moins importante d'un solvant organique (5) qui peut représenter jusqu'à 95 % en poids de la composition et de préférence, au maximum 80 %.

On utilise alors un solvant organique volatile compatible avec la composition choisi par exemple parmi les alcanes, les coupes pétrolières renfermant des composés paraffiniques, le toluène, l'heptane, le xylène, l'isopropanol, la méthylisobutylcétone, le tétrahydrofuranne, le chlorobenzène, le chloroforme, le trichloro-1,1,1 éthane, les dérivés du monoéthylèneglycol et de méthylèneglycol.

Pour cent parties en poids de composé (1) on peut utiliser de 0,1 à 50 parties de composés (2) et de 0,005 à 3 parties, de préférence de 0,01 à 0,5 parties en poids de composé (4).

La composition selon l'invention peut également renfermer des additifs divers pour en améliorer, notamment l'adhérence.

Sans être liée par une théorie scientifique on peut expliquer les propriétes extrèmement avantageuses de l'inhibiteur selon l'invention de la façon suivante :

L'inhibiteur (4) selon l'invention présente en effet un mode de complexation avec le catalyseur complètement different des autres inhiteurs connus. Ainsi, lors de l'établissement d'un spectre par résonance magnétique nucléaire (RMN) du $^{195}Pt$, un complexe catalyseur-inhibiteur (par exemple, dans le cas où l'inhibiteur est le maléate de méthyle décrit dans le brevet français n° 2.456.767) fait apparaître un signal caractéristique de la formation d'un complexe diamagnétique.

Or un tel signal par RMN du $^{195}$ Pt n'apparaît pas quand l'inhibiteur (4) est un ester azodicarboxylique. Par contre, un signal apparaît lors de l'établissement d'un spectre par résonance paramagnétique électronique (RPE) qui met en évidence la formation d'un complexe paramagnétique du platine, ce signal n'apparaissant pas avec des inhibiteurs connus, en particulier le maléate de méthyle.

Ce complexe paramagnétique devient diamagnétique après irradiation U.V., le platine est activé et l'azodicarboxylate est transformé en hydrazine correspondante. Le complexe paramagnétique se forme pour les faibles degrés d'oxydation du platine, et plus précisément pour les degrés d'oxydation 0 et II dans, le composé catalytique (3) tel que défini ci-dessus.

L'intérêt majeur de la formation de ce complexe paramagnétique est que, contrairement au complexe diamagnétique il est beaucoup plus stable, en particulier à température élevée.

Par conséquent la durée de vie en pot ou en bain des compositions ainsi inhibées ainsi que celle de films formés à partir de ces compositions dans certaines conditions est plus importante. Pour détuire le complexe paramagnétique et activer le catalyseur il est nécessaire de transformer le complexe paramagnétique en

complexe diamagnétique en soumettant une couche mince de la composition organopolysiloxanique à une rayonnement U.V..

Comme les spécialistes le savent bien, les compositions organopolysiloxanes peuvent présenter des viscosité plus ou moins élevées. Certains matériaux hautement visqueux, voire pâteux, pouvant le cas échéant se présenter sous forme d'une gomme plus ou moins solide devront être dilués dans un solvant pour amener la viscosité à une valeur compatible avec le mode d'application envisagé. Certaines compositions sont fluides même en l'absence d'un solvant et elle pourront être stockées plusieurs jours sans modification sensible de leur viscosité.

Toutefois comme cela a été indiqué en tête du présent mémoire, la présente invention a également pour objet un substrat comportant au moins une surface revêtue d'un film adhérent uniforme et d'une épaisseur comprise entre 0,1 et 3 micromètres environ et formé à partir d'une telle composition et, un procédé d'application de la composition pour former une image sur un substrat.

Par substrat, on entend plus particulièrement dans le cas présent des plaques, des tranches, des éléments de plaques ou tranches réalisées en matériaux utilisés dans la fabrication de composants ou supports de composants électroniques.

Comme substrat on peut citer les tranches (ou les puces) de silicium revêtues on non d'une couche d'oxyde ou de nitrure, des plaques en céramiques et des plaques revêtues d'aluminium ; on peut également considérer comme substrat approprié les mêmes surfaces revêtues d'une première couche de planéification par exemple en une novolaque, ou en tout autre matériau polymérique approprié et bien connu de l'homme de métier.

Le procédé comprend la formation d'un film adhérent sur la surface à partie de la composition qui vient d'être décrite, l'irradiation d'au moins une portion de ce film par un rayonnement ultra-violet ce qui va causer le durcissement de la partie insolée, la partie non-irradiée restant soluble dans les solvants organiques compatibles avec les compositions polysiloxanes.

Si certaines compositions selon l'invention présentent une viscosité relativement faible en l'absence de solvant (viscosité mesurée à 25°C inférieure à 5 000 m Pa.s), le plus souvent la composition organopolysiloxane sera diluée dans un solvant approprié pour lui conférer une viscosité compatible avec le dépôt d'une couche mince par l'intermédiaire d'une tournette. Elle sera filtrée au préalable si besoin est.

Par le choix d'une vitesse de rotation de la tournette, de la nature du solvant et de la viscosité de la composition une couche mince sera déposée sur le substrat de telle sorte qu'après élimination du solvant à une température inférieure à 50°C et de préférence inférieure à 45°C, il reste en place un film mince d'une épaisseur généralement comprise entre 0,1 et 3 micromètres environ, et de préférence de l'ordre de 1 à 2 micromètres si l'on opère en monocouche, et de l'ordre de 1 000 à 2 000 Angströms si l'on opère en bi- ou multicouche.

La formation du film à partir de la composition en cause pourra se faire sur une première couche dite de planéification telle qu'une novolaque (par exemple), les deux couches peuvent aussi être séparées par au moins une autre couche d'un autre matériau polymérique

On irradie alors sélectivement des zones du film, par exemple, par un rayonnement U.V. à travers un masque. La longueur d'onde dans ce cas est comprise entre 200 et 400 nanomètres et de préférence de l'ordre de 254 et 360 nanomètres.

Après irradiation on révèle l'image en dissolvant les parties non irradiées du film par pulvérisation ou au trempé dans un solvant organique qui peut être le même que celui utilisé pour diluer la composition de départ.

Il est alors possible de rincer et/ou de recuire les parties de la couche qui restent sur le substrat le cas échéant, et de procéder alors à la gravure par un agent chimique ou par un plasma.

Les exemples ci-après illustrent l'invention.

Exemple 1 :

On prépare une composition silicone constituée par un mélange de:

.48%, en poids, d'une résine polysiloxane contenant environ 2,8%, en poids, de groupements vinyle liés à des atomes de silicium,

.43,3%, en poids, de polymère polydiméthylsiloxane sensiblement linéaire, à terminaison diméthylvinylsiloxy, contenant environ 2,7%; en poids, de groupements vinyle et présentant une viscosité à 25°C d'environ 20 m Pa.s,

.2,3% de tétraméthyl-1,3,5,7 tétravinyl-1,3,5,7 cyclotétrasiloxane,

.6,4% d'un fluide polyméthylhydrogénosiloxane à terminaisons triméthylsiloxy, comprenant environ 1,5%, en poids, d'atomes d'hydrogène liés au silicium, et ayant une viscosité à 25°C d'environ 20 m Pa.s.

A ce mélange, on ajoute 0,04%, en poids d'azodicarboxylate d'éthyle (ADCE), soit $2,3 \times 10^{-3}$ mole/kg de composition ; l'ADCE dilué dans du toluène (concentration : 10g d'ADCE par litre de solvant), est coulé goutte à goutte dans le mélange polysiloxane vigoureusement agité.

De la même manière, on ajoute 50 ppm de platine ($2,5 \times 10^{-4}$ at.g de platine par kg de composition) sous la forme d'un complexe préparé à partir de l'acide chloroplatinique et de divinyl-1,3 tétraméthyl-1,1,3,3 disiloxane, comme décrit dans le brevet US 3.824.730 ; on utilise une solution de ce complexe dans le toluène (concentration de la solution : 1g de platine par litre de solvant).

Le composition résultante est ensuite étalée en couche mince sur la surface d'une tranche de silicium monocristallin.

Le dépôt du film est effectué à l'aide d'une tournette fonctionnant à 3000 tours/mn.

On procède ensuite à l'évaporation du toluène par un chauffage à l'étuve à 50° C, pendant une heure.

Une partie de la surface de la tranche de silicium est protégée par un cache opaque au rayonnement U.V.

Puis le films est exposé à un rayonnement U.V. pendant 5 mn. Cette opération a été réalisée avec un appareil TAMARACK SCIENTIFIC INC., modèle PRX 350-4, équipé d'une lampe à mercure de type HBO, de 350 W.

Après développement, pendant 5 à 10 s, dans du toluène, on peut constater qu'un film polysiloxane adhérent recouvre la zone irradiée, tandis qu'aucune trace de matériau silicone n'est décelable dans la zone non exposée.

Exemples 2 et 3 :

La procédure et les matières premières sont identiques à celles décrites dans l'exemple 1.

On a simplement fait varier les concentrations en ADCE et en platine, ainsi que les durées d'exposition au rayonnement U.V.

Exemple 4 :

Dans cet exemple, on a utilisé une autre variante du catalyseur d'hydrosilylation, qui est le produit de la réaction de l'acide chloroplatinique sur l'octanol conformément à l'enseignement du brevet US 3.220.972.

Les autres constituants du mélange, ainsi que la procédure de mise en oeuvre, sont identiques à ceux des exemples 1, 2 et 3. Les conditions particulières ainsi que les résultats obtenus sont rassemblés sur le tableau ci-après.

| EXEMPLE | CONCENTRATION EN ADCE (% en poids) | CONCENTRATION EN PLATINE ( ppm) | DUREE D'EXPOSITION (en mn ) |
|---|---|---|---|
| 1 | 0,04 | 50 | 5 |
| 2 | 0,1 | 77 | 30 |
| 3 | 0,75 | 116 | 10 |
| 4 | 0,1 | 54 | 32 |

**Revendications**

1) Utilisation comme résist négatif d'une composition organopolysiloxane filmogène et réticulable par réaction d'hydrosilylation en présence d'un catalyseur issu d'un métal du groupe du platine, l'activité du catalyseur étant bloquée de manière réversible par un inhibiteur, le déblocage de l'activité catalytique étant pour l'essentiel réalisable par insolation à la lumière ultra-violette comprenant essentiellement :

1) au moins un organopolysiloxane contenant par molécule au moins x groupes hydrocarbonés à insaturation alcényle liés à un atome de silicium, avec x supérieur ou égal à 2,

2) au moins un organohydrogénopolysiloxane contenant par molécule au moins y atomes d'hydrogène liés à un atome de silicium avec y supérieur ou égal à 2,

(x + y) étant supérieur ou égal à 5,

les groupements SiH et Si-alcényle pouvant être portés par la même molécule,

3) une quantité catalytiquement efficace d'un composé d'un métal du groupe du platine,

4) une quantité d'au moins un azodicarboxylate efficace pour inhiber la formation d'un gel à température ambiante mais en quantité insuffisante pour empêcher la réticulation lors de l'insolation

au rayons ultra-vilolets, et

5) le cas échéant, un solvant organique.

2) Utilisation selon la revendication 1, caractérisée en ce que, dans la composition, le rapport du nombre de groupement SiH aux groupements vinyle est compris entre 0,7 et 1,4 .

3) Utilisation selon la revendication 1 ou 2, caractérisée en ce que, dans la composition, l'inhibiteur (4) comprend le groupe - 00C - N = N - C00 -, chaque groupe carboxylate étant rélié à un radical organique sans influence défavorable sur l'activité catalytique du composé (3), et est liquide à 25° C ou s'il est solide à cette température, soluble dans un solvant organique compatible avec les compositions organosiloxanes.

4) Utilisation selon la revendication 1 ou 2, caractérisée en ce que, dans la composition, l'inhibiteur (4) est choisi parmi les produits de formule :

$R_1OOC - N = N - COOR_2$ (I)

$R'_1OOC - N = N - COO - R - OOC - N = N - COOR'_2$ (II)

dans lesquelles $R_1$, $R_2$, $R'_1$, $R'_2$ identiques ou différents représentant une chaîne alkyle linéaire ou ramifiée ayant de 1 à 12 atomes de carbone et R représente une chaîne alkylène de formule $-(CH_2)-_n$ avec n étant un nombre entier compris entre 1 et 12, ou une chaîne $-CH_2-CH_2-O-CH_2-CH_2-$.

5) Utilisation selon l'une quelconque des revendications 1 à 4, caractérisée en ce que, dans la composition, le composé (4) est l'azodicarboxylate d'éthyle.

6) Substrat comportant au moins une surface révêtue d'un film adhérent uniforme et d'une épaisseur comprise entre 0,1 et 3 micromètres environ et formé à partir d'une composition selon l'une quelconque des revendications 1 à 5 ci-avant.

7) Substrat selon la revendication 6 caractérisé en ce que ladite surface et ledit film sont séparés par au moins une couche intermédiaire.

8) Substrat selon la revendication 6 ou 7 caractérisé en ce que ladite surface est située sur un matériau choisi dans le groupe constitué par le silicium, le silicium revêtu d'une couche d'oxyde ou de nitrure, les céramiques et l'aluminium.

9) Substrat selon la revendication 6 ou 7 caractérisé en ce que ladite surface est située sur une tranche de silicium le cas échéant revêtue d'une couche d'oxyde ou de nitrure.

10) Procédé pour former une image à la surface d'un substrat comprenant les étapes suivantes :

- on forme un film en utilisant une composition selon l'une quelconque des revendications 1 à 5, la température étant toutefois inférieure à 50° C et, de préférence, inférieure à 45° C dont l'épaisseur est comprise entre 0,1 et 3 micromètres environ,
- on irradie au moins une portion du film pendant un temps suffisant pour initier la réticulation et, on révèle l'image en éliminant les parties non irradiées.

11) Procédé selon la revendication 10, caractérisé en ce que le film est formé par application à la tournette d'un couche mince d'une composition diluée dans un solvant suivie de l'élimination du solvant à une température inférieure à 50° C et, de préférence inférieure à 45° C et en ce que la révélation de l'image est réalisée en dissolvant les parties non irradiées dans un solvant qui peut être le même que celui de la composition initiale.

Office européen des brevets

# RAPPORT DE RECHERCHE EUROPEENNE

Numéro de la demande

EP 87 42 0085

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A,P | FR-A-2 571 732 (RHONE-POULENC) * Revendications 1-9; page 8, paragraphes 6,7; page 9, paragrahe 3 * | 1-5,7 | C 08 L 83/07<br>G 03 F 7/10 //<br>(C 08 L 83/07<br>C 08 L 83:05 ) |
| Y | DE-A-2 246 020 (PAI NIPPON PRINTING) * Revendications 1,5; page 3, paragraphe 2; page 4, paragraphes 1,2; page 5, paragraphe 3; page 27, paragraphes 3,4; page 28, paragraphe 1; page 29, paragraphe 2 * | 1,6-10 | |
| Y | EP-A-0 153 700 (TORAY SILICONE) * Revendication 1 * | 1,6-10 | |
| A | FR-A-2 507 608 (RHONE-POULENC) * Revendication 1 * | 1 | DOMAINES TECHNIQUES RECHERCHES (Int. Cl.4)<br>C 08 L<br>G 03 F |

Le présent rapport de recherche a été établi pour toutes les revendications

| Lieu de la recherche | Date d'achèvement de la recherche | Examinateur |
|---|---|---|
| LA HAYE | 26-08-1987 | DEPIJPER R.D.C. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant